# EUROPÄISCHE PATENTSCHRIFT

(11) **EP 1 900 436 B1**
(45) Veröffentlichungstag und Bekanntmachung des Hinweises auf die Patenterteilung: **21.12.2011**
(21) Anmeldenummer: 07115953.7
(22) Anmeldetag: 07.09.2007
(51) Int. Cl.: B05B 1/30, B05B 7/20, B05C 1/00, B05D 1/08, B05D 3/00, C23C 4/12, C23C 16/453

(54) **Verfahren zum Beschichten von Oberflächen**
Method for coating surfaces
Procédé de revêtement de surfaces

(30) Priorität: 12.09.2006 DE 102006043542
(43) Veröffentlichungstag der Anmeldung: 19.03.2008
(73) Patentinhaber: Innovent e.V., 07745 Jena (DE)
(72) Erfinder: Staude, Maik, 07768, Kahla (DE); Heft, Andreas, 07545, Gera (DE); Krippl, Gerhardt, 07646, Stadtroda (DE); Grünler, Bernd, 07937, Zeulenroda (DE); Schimanski, Arnd, 44329, Dortmund (DE); Tiller, Hans-Jürgen, 07749, Jena (DE)
(74) Vertreter: Liedtke, Markus

(56) Entgegenhaltungen:
- EP-A1- 0 029 809
- EP-A1- 0 158 468
- FR-A1- 2 518 429
- US-A1- 2006 127 599

## Beschreibung

Die Erfindung betrifft ein Verfahren zum Beschichten von Oberflächen.

Bei der Beschichtung von Oberflächen, beispielsweise zur Haftvermittlung oder zur Beeinflussung optischer Eigenschaften wie der Transmission werden möglichst gleichmäßige Schichtstärken im Nanometerbereich angestrebt. Gebräuchliche Verfahren zur Beschichtung von Oberflächen sind beispielsweise die flammengestützte Abscheidung und die Flammenpyrolyse von metallischen Oxiden. Hierzu werden so genannte Precursoren einem Trägergas in einem Brenner zugesetzt, die bei der Verbrennung des Trägergases thermisch umgesetzt und deren dabei entstehende Reaktionsprodukte, beispielsweise Metalloxide, auf der Oberfläche als Beschichtung angelagert werden. Für flächige Oberflächenbehandlung werden meist längliche Brenner verwendet, die mit ihrer Länge entsprechend vielen Einzelbohrungen versehen sind, die als Düsen fungieren. Des Weiteren sind zahlreiche andere Bauformen bekannt, welche eine gleichmäßige Verteilung der Einzelflammen auf bestimmte Länge zeigen, jedoch ein sehr inhomogenes Flammenbild bieten, zumindest bezüglich der Beschichtungsstärken im Nanometerbereich. Dies führt zu einer nicht unerheblichen Streifenbildung auf den zu beschichtenden Oberflächen. Diese Streifenbildung zeigt sich bei sehr geringen Abständen zwischen Brenner und Substrat, und hat einen erheblichen Einfluss auf Oberflächenprofile, Schichtdicken, Rauhigkeiten und die damit verbundenen physikalischen Eigenschaften. Des Weiteren wird der hohe Energieeintrag der üblichen Brenner z.B. für Beschichtungen nicht benötigt, und ist sogar in vielen Fällen, wie bei der Beschichtung von Kunststoffen für Haftvermittlungszwecke störend. Ein weiterer Nachteil herkömmlichen Brennerbauformen ist der hohe Gasverbrauch, der zur optimalen chemischen Umsetzung der Beschichtungsstoffe nötig ist. Um relativ homogene Schichten erzielen zu können, ist es nach den bekannten Verfahren erforderlich, einen großen Abstand zwischen dem Brenner und der zu beschichtenden Oberfläche einzuhalten. Nachteilig ist dabei ein erheblicher Energieverlust in Form von Wärme.

Der Erfindung liegt die Aufgabe zu Grunde, ein verbessertes Verfahren zum Beschichten von Oberflächen anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei dem erfindungsgemäßen Verfahren zum Beschichten von Oberflächen wird ein Gemenge, das als Komponenten mindestens ein Trägergas und mindestens einen Precursor und/oder mindestens eine Beschichtungskomponente enthält, in eine Gasverteilungseinheit oder einen Brenner eingeleitet oder das Gemenge dort aus den einzeln eingeleiteten Komponenten gebildet. Das Gemenge wird dann aus der Gasverteilungseinheit oder dem Brenner in einen gasdicht daran anschließenden Homogenisator geleitet. Dieser umfasst einen sich in Richtung einer schlitzförmigen Ausströmöffnung verjüngenden Raum. Der Raum wird zum einen durch zwei einander gegenüber liegende Führungsplatten an den Längsseiten der schlitzförmigen Ausströmöffnung und zum anderen durch zwei einander gegenüber liegende Seitenführungsplatten an den Querseiten der schlitzförmigen Ausströmöffnung begrenzt, so dass sich ein im Wesentlichen rechteckiger Strömungsquerschnitt ergibt. Anstelle jeder der Führungsplatten kann auch jeweils eine Folge von Führungsplattensegmenten vorgesehen sein. Infolge der Verjüngung des Raumes entstehen Turbulenzen, die für eine Homogenisierung des Gemenges sorgen. Das homogenisierte Gemenge wird aus der Ausströmöffnung in Richtung der zu beschichtenden Oberfläche ausgeströmt und an dieser die Beschichtungskomponente und/oder mindestens ein Reaktionsprodukt des Precursors angelagert. Der dem Trägergas zugesetzte Precursor wird infolge der Verbrennung des Trägergases im Homogenisator und/oder an der Austrittsöffnung chemisch zu mindestens einem Reaktionsprodukt umgesetzt und als Beschichtung auf der Oberfläche angelagert. Alternativ kann ein Precursor oder eine Beschichtungskomponente einem als Trägergas dienenden Gasstrom, insbesondere einem Heißgasstrom zugesetzt sein, der ohne Verbrennung aus der Ausströmöffnung ausgeströmt wird, wobei die Beschichtungskomponente oder ein Reaktionsprodukt des Precursors sich auf der Oberfläche anlagert. Brenner und Gasverteilungseinheiten sind Düsen oder Anordnungen von Düsen. Insbesondere zur flächigen Oberflächenbeschichtung sind längliche Brenner mit einer Vielzahl von Einzeldüsen gebräuchlich. Der Einsatz des auf den Brenner oder die Gasverteilungseinheit aufgesetzten Homogenisators sorgt einerseits für eine Homogenisierung des Precursors bzw. der Beschichtungskomponente im Trägergas, andererseits für einen homogenen Austritt des Gemenges entlang der schlitzförmigen Ausströmöffnung, so dass sich, anders als bei einer nur mit dem Brenner stattfindenden Beschichtung keine oder nur geringe Inhomogenitäten in der Dicke der Beschichtung ergeben, da ein homogener Flammenbalken mit definierter Flammenhöhe aus der Ausströmöffnung austritt. Im Falle der Verwendung von Führungsplattensegmenten ist der Flammenbalken abschnittsweise homogen, beispielsweise für den Fall, dass in verschiedenen Bereichen der Oberfläche unterschiedliche Beschichtungsstärken realisiert werden sollen. Die Verjüngung des Raumes bewirkt außer der Homogenisierung auch eine Erhöhung des dynamischen Druckes des Gemenges, was zu einer erhöhten Austrittsgeschwindigkeit des Gemenges mit einem verringerten Verbrauch an Trägergas führt. Vorteilhaft ist weiter die Verwendbarkeit eines herkömmlichen Brenners, der mit dem Homogenisator kostengünstig aufrüstbar ist und durch Entfernen desselben gegebenenfalls wieder in seinen ursprünglichen Zustand zurück versetzt werden kann. Der Homogenisator ist so gebildet, dass keine der Düsen oder Öffnungen des Brenners oder der Gasverteilungseinheit verdeckt ist, um einen optimalen Gasdurchfluss zu ermöglichen. Das beschriebene Verfahren ermöglicht einen sehr geringen Abstand zwischen der Ausströmöffnung und der zu beschichtenden Oberfläche, so dass der Energieeintrag dort effizienter ist.

Die Verjüngung kann sich über den gesamten Bereich mindestens einer der Führungsplatten oder mindestens eines der Führungsplattensegmente zwischen einer Einströmöffnung des Homogenisators, die an die Düse bzw. die Gasverteilungseinheit oder bei direkter Einleitung des Gemenges an eine Zuleitung angrenzt, und der Ausströmöffnung oder über einen oder mehrere Teile dieses Bereiches erstrecken. Als Verjüngung soll hier auch eine lokale Einschnürung des Strömungsquerschnitts oder eine Folge solcher Einschnürungen verstanden werden, wobei sich der Strömungsquerschnitt nach der Einschnürung wieder vergrößert. Die Verjüngung kann linear oder nichtlinear erfolgen.

In einer alternativen Ausführungsform wird das als Komponenten mindestens ein Trägergas und mindestens einen Precursor und/oder mindestens eine Beschichtungskomponente enthaltende Gemenge in den Homogenisator eingeleitet oder dort aus den Komponenten gebildet. Der separate Brenner bzw. die Gasverteilungseinheit entfallen hier, da der Homogenisator deren Aufgaben übernimmt. Weitere Wirkungen und Vorteile entsprechen den vorgenannten.

Die Verjüngung wird erfindungsgemäß erzielt, indem mindestens eine der Führungsplatten oder mindestens eines der Führungsplattensegmente eine Neigung aufweist. Insbesondere sind beide Führungsplatten oder alle Führungsplattensegmente mit einer solchen Neigung versehen. Die Verjüngung ist auf diese Weise mit flächigen Führungsplatten besonders einfach und kostengünstig zu realisieren, da in die Führungsplatten keine zusätzlichen Strukturen für die Verjüngung eingearbeitet oder solche auf die Führungsplatten aufgebracht werden müssen..

In einer bevorzugten Ausführungsform weist die Ausströmöffnung eine Schlitzbreite auf, die durch Schwenken mindestens einer der Führungsplatten oder mindestens eines der Führungsplattensegmente eingestellt wird. Vorzugsweise werden beide Führungsplatten synchron geschwenkt. Die Verstellung der Schlitzbreite ermöglicht eine Feinabstimmung der Charakteristik des aus der Ausströmöffnung austretenden Gemenges, um Durchflussmenge und Energieeintrag an die zu beschichtende Oberfläche anzupassen. Die Einstellbarkeit der Führungsplattensegmente ermöglicht eine abschnittsweise Feinabstimmung.

Für die Beschichtung von Oberflächen, die von einer ebenen Form abweichen, beispielsweise gewölbt sind, wird vorzugsweise ein Homogenisator mit an diese Oberfläche angepasster Form verwendet, im Falle der Wölbung einer die Wölbung nachvollziehenden Form mit definiertem, vorzugsweise gleichem Abstand zwischen der Ausströmöffnung und der Oberfläche über deren gesamte Breite durch entsprechende Formgebung der Führungsplatten. Auf diese Weise ist beispielsweise auch eine Oberfläche mit gezackter Form beschichtbar.

Vorzugsweise wird neben dem Abstand der Ausströmöffnung von der Oberfläche auch eine Vorschubgeschwindigkeit einer zwischen der Oberfläche und der Ausströmöffnung stattfindenden Relativbewegung bei vorgegebenem Abstand und/oder eine Anzahl von Beschichtungszyklen, in denen die Relativbewegung stattfindet, eingestellt und/oder gesteuert und/oder geregelt. Da die Beschichtung der Oberfläche mit dem Homogenisator quasi eindimensional erfolgt, muss dieser relativ zur Oberfläche verschoben werden, was sowohl durch eine Verschiebung der Oberfläche als auch des Brenners oder der Gasverteilungseinheit mit dem Homogenisator erfolgen kann. Auf diese Weise kann eine definierte Beschichtungsdicke erzielt werden. Weitere Einflussgrößen sind hier die Mischungsverhältnisse der im Trägergas enthaltenen Substanzen, beispielsweise Propan und Luft oder Sauerstoff untereinander und mit dem Precursor.

Bevorzugt wird als Precursor ein Stoff verwendet, dessen Reaktionsprodukt ein sauerstoffhaltige Verbindung und/oder ein chemisches Element und/oder ein Beschichtungsgemenge aus mindestens einer sauerstoffhaltigen Verbindung und/oder mindest einem chemischen Element ist. Solche sauerstoffhaltigen Verbindungen sind zum Beispiel Oxide der Elemente Wolfram, Vanadium, Aluminium, Titan oder Silizium. Diese Metalloxide eignen sich beispielsweise zur Beschichtung von optischen Oberflächen zur Beeinflussung der Transmissionseigenschaften. Als chemische Elemente kommen beispielsweise Silber oder Kohlenstoff zum Einsatz.

Ausführungsbeispiele der Erfindung werden im Folgenden anhand von Zeichnungen näher erläutert.

Darin zeigen:
- Figur 1: eine Seitenansicht einer Anordnung mit einer zu beschichtenden Oberfläche, einem Brenner und einem Homogenisator zur Durchführung eines Verfahrens zur Beschichtung der Oberfläche,
- Figur 2: eine Ansicht der Anordung aus Figur 1 von vorn,
- Figur 3: eine Ansicht einer Anordnung mit einer zu beschichtenden, gewellten Oberfläche, einem Brenner und einem Homogenisator zur Durchführung eines Verfahrens zur Beschichtung der Oberfläche,
- Figur 4: eine Ansicht einer Anordnung mit einer zu beschichtenden, unstetigen Oberfläche, einem Brenner und einem Homogenisator zur Durchführung eines Verfahrens zur Beschichtung der Oberfläche,
- Figur 5: eine Ansicht einer Anordnung mit einem komplexen Körper mit vier unebenen zu beschichtenden Oberflächen, vier Brennern mit jeweils einem Homogenisator zur Durchführung eines Verfahrens zur Beschichtung der Oberflächen,
- Figur 6: eine perspektivische Ansicht eines Brenners mit zu einem Homogenisator gehörenden Führungsplattensegmenten und
- Figur 7: eine Draufsicht auf einen Homogenisator mit Führungsplattensegmenten.

Einander entsprechende Teile sind in allen Figuren mit den gleichen Bezugszeichen versehen.

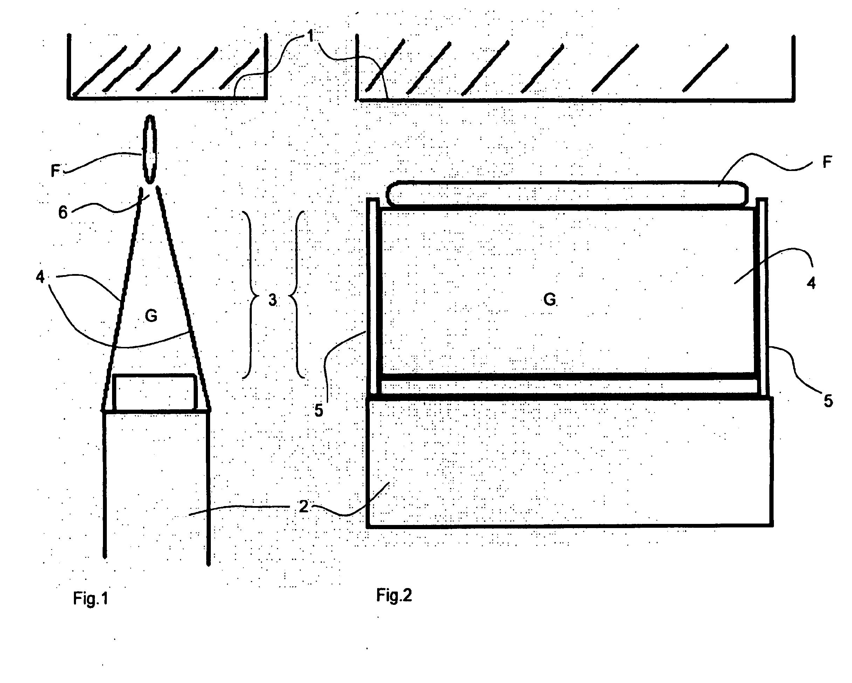

**Figur 1** zeigt eine Seitenansicht einer Anordnung mit einer zu beschichtenden Oberfläche 1, einem Brenner 2 und einem Homogenisator 3 zur Durchführung eines Verfahrens zur Beschichtung der Oberfläche 1. Dieselbe Anordnung ist auch in **Figur 2** gezeigt, jedoch in einer Ansicht von vorn.

In dem Verfahren zur Beschichtung der Oberfläche 1 wird in den länglich gestalteten Brenner 2 ein Gemenge G aus einem brennbaren Trägergas und einem Precursor eingeleitet. In einem Gasaustrittsbereich des Brenners 2 ist auf dem Brenner 2 ein Homogenisator 3 gasdicht angeordnet. Er umfasst zwei einander gegenüber liegende Führungsplatten 4 und zwei einander gegenüber liegende Seitenführungsplatten 5, die einen Raum mit einem rechtwinkligen Strömungsquerschnitt begrenzen. Die Führungsplatten 4 sind so gegeneinander geneigt, dass der Raum sich zu einer schlitzförmigen Ausströmöffnung 6 hin verjüngt. Beim Durchströmen des Homogenisators 3 bilden sich wegen des steigenden dynamischen Druckes infolge der Verjüngung Turbulenzen aus, die für eine Homogenisierung des Gemenges G sorgen. Außerdem strömt das Gemenge G so homogen aus der Ausströmöffnung 6, dass sich, wenn das Trägergas brennbar ist und entzündet wird, eine homogene balkenartige Flamme F ausbildet. Der Precursor wird in der Flamme F chemisch zu mindestens einem Reaktionsprodukt umgesetzt und dieses auf der Oberfläche 1 angelagert. Die Anlagerung erfolgt aufgrund der Homogenität der Flamme F mit definierter und außerordentlich gleichmäßiger Schichtdicke. Die Führungsplatten 4 sind in ihrer Neigung so verstellbar, dass sich eine unterschiedliche Breite der Ausströmöffnung 6 und infolgedessen unterschiedliche Strömungsgeschwindigkeiten des Gemenges G und damit unterschiedliche Längen der Flamme F ergeben. Figur 1 zeigt eine längere, Figur 2 eine kürzere Flamme infolge unterschiedlich eingestellter Führungsplatten 4. Die Verstellung kann beispielsweise durch Schwenken um jeweils eine in Längsrichtung des Brenners 2 liegende Achse an dem Ende der Führungsplatte 4, die an den Brenner 2 angrenzt, erfolgen. Die Führungsplatten 4 und Seitenführungsplatten 5 sind vorzugsweise aus Metallblech gebildet.

Da die Beschichtung der Oberfläche 1 mit dem Homogenisator 3 quasi eindimensional erfolgt, muss dieser relativ zur Oberfläche 1 verschoben werden, was sowohl durch eine Verschiebung der Oberfläche 1 als auch des Brenners 2 mit dem Homogenisator 3 erfolgen kann. Auf diese Weise kann eine definierte Beschichtungsdicke erzielt werden. Die Verschiebung erfolgt in Figur 1 in seitlicher Richtung und in Figur 2 in Normalrichtung zur Figur. Zur Beschichtung von Oberflächen 1 aus Glas können beispielsweise Transportbänder benutzt werden, auf denen das Glas unter der aus dem Homogenisator 3 austretenden Flamme F verschoben wird. Zur Durchführung mehrerer Beschichtungszyklen kann das Glas entsprechend häufig vor und zurück verschoben oder eine entsprechende Anzahl an Brennern 2 mit Homogenisatoren 3 verwendet werden.

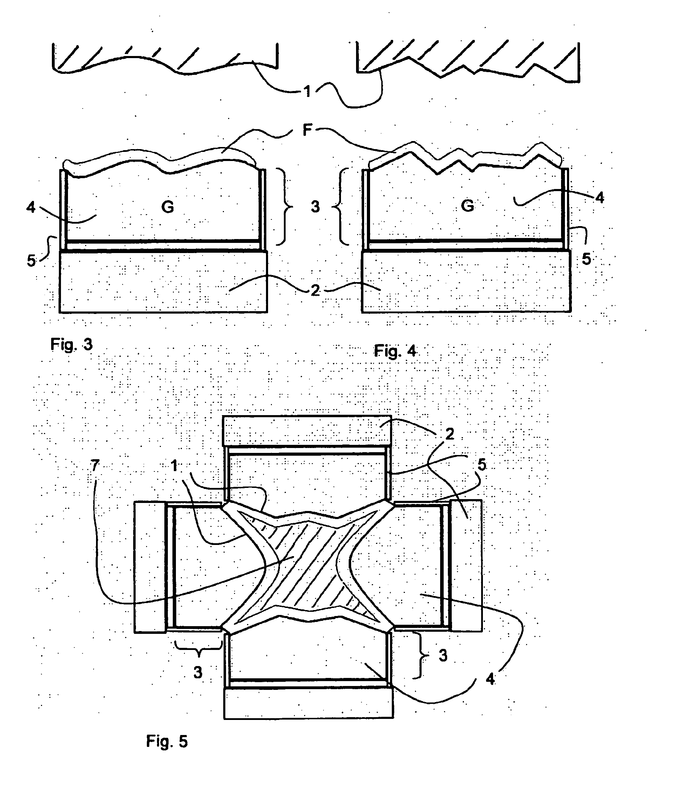

Die in **Figur 3** gezeigte Anordnung entspricht der in Figur 2 gezeigten mit dem Unterschied, dass die Oberfläche 1 uneben, hier wellig geformt ist. Die Führungsplatten 4 und damit die Ausströmöffnung 6 sind entsprechend dieser Oberflächenform gebildet, so dass die Flamme F überall den gleichen Abstand zur Oberfläche 1 aufweist.

Die in **Figur 4** gezeigte Anordnung entspricht der in Figur 3 gezeigten mit dem Unterschied, dass die Oberfläche 1 uneben, hier unstetig gezackt geformt ist. Die Führungsplatten 4 und damit die Ausströmöffnung 6 sind entsprechend dieser Oberflächenform gebildet, so dass die Flamme F überall den gleichen Abstand zur Oberfläche 1 aufweist.

In **Figur 5** ist ein komplexer Körper 7 in einer Querschnittsdarstellung gezeigt. Er weist vier unebene Oberflächen 1 auf, die beschichtet werden sollen. Hierzu sind vier Brenner 2 mit jeweils zugehörigen Homogenisatoren 3 angeordnet, deren Führungsplatten 4 entsprechend der durch sie zu beschichtenden Oberflächen 1 geformt sind. Für eine vollständige Beschichtung der Oberflächen des komplexen Körpers 7 wird dieser beispielsweise in Richtung seiner Längsausdehnung durch die Homogenisatoren 3 geschoben. Der Vorgang wird so oft wiederholt, bis die gewünschte Beschichtungsstärke erreicht ist.

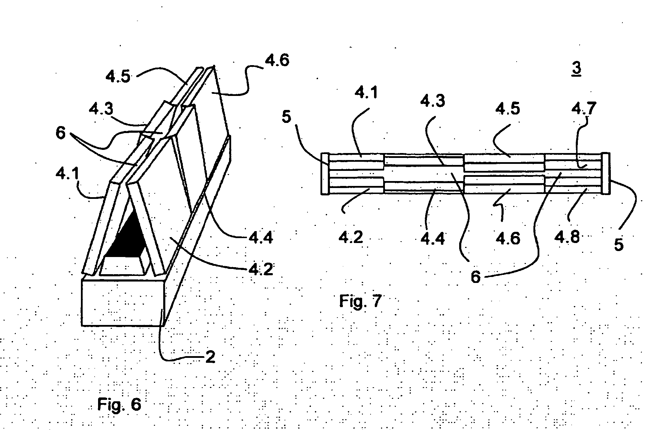

In **Figur 6** ist exemplarisch ein Brenner 2 mit zu einem Homogenisator 3 gehörenden Folgen von Führungsplattensegmenten 4.1 bis 4.6 gezeigt, die zur abschnittsweisen Verstellung der Breite der schlitzförmigen Ausströmöffnung 6 einzeln schwenkbar sind, um die Charakteristik der Flamme F oder des Gasstroms und somit die Beschichtungseigenschaften der Oberfläche 1 abschnittsweise einstellen zu können.

**Figur 7** zeigt eine Draufsicht auf einen Homogenisator 3 mit Folgen von Führungsplattensegmenten 4.1 bis 4.8 und Seitenführungsplatten 5, um die abschnittsweise unterschiedliche Breite der schlitzförmigen Ausströmöffnung 6 zu verdeutlichen.

Im Folgenden werden zwei konkrete Ausführungsbeispiele für ein Verfahren zur Beschichtung einer Oberfläche 1 beschrieben.

### Beispiel 1:

Ein als Trägergas dienendes Propan-Luft-Gemisch und ein silanhaltiger Precursor werden zusammen in den Brenner 2 eingespeist und von dort in den Homogenisator 3 überführt. Hierbei dient der Homogenisator 3 der Vermischung und somit der homogenen Verteilung des Precursors im Trägergas. Der Precursor wird in der Flamme F umgesetzt und als Oxid auf der zu beschichtenden Oberfläche 1 abgeschieden, wodurch sich Veränderungen der physikalischen Eigenschaften dieser Oberfläche 1 erzielen lassen. Die zu beschichtende Oberfläche 1 im Beispiel ist aus Glas gebildet. Zur Erzeugung einer transmissionserhöhenden Schicht auf der Oberfläche 1 wird als Trägergas ein Propan-Luft-Gemisch im Verhältnis 1:25 eingesetzt. Der Durchsatz beträgt 3 1/min Propan und 75 1/min Luft. Des Weiteren wird dem Gemenge G Silan als Precursor bei einem Durchsatz von 0,5 1/min zugesetzt. Um ausreichende Schichtdicken im Bereich von 80 nm zu erreichen, sind folgende Parameter zu wählen: Abstand der Austrittsöffnung 6 zur Oberfläche 1 zwischen 6 mm und 12 mm, Vorschubgeschwindigkeit der Relativbewegung zwischen Oberfläche 1 und Homogenisator 3 von 0,4 m/s bis 0,8 m/s, 10 bis 30 Beschichtungszyklen. Als Precursor kommt HMDSO (Hexamethyldisiloxan) oder TEMOS (Tetramethyloxisilan) zur Anwendung, beispielsweise zur Abscheidung von Transmissionserhöhungs- , oder Haftvermittlungsschichten auf Glas.

### Beispiel 2:

Erzeugen homogen ausströmender und reaktiver Gasmengen welche der Beschichtung und der Herstellung photokatalytischer Oberflächen wie zum Beispiel Glas dienen.

Die reaktiven Trägergase und Precursoren mit Temperaturen von 20°C bis 120°C, insbesondere 80°C, werden in eine Gasverteilungseinheit analog dem abgebildeten Brenner 2 eindosiert, in den Homogenisator 3 überführt und anschließend aus der Ausströmöffnung 6 homogen auf die Oberfläche 1 aufgesprüht. Hierbei dient der Homogenisator 3 mit der schlitzförmigen Ausströmöffnung 6 als Precursorsprühleiste, so dass das Gemenge in jedem Abschnitt der Ausströmöffnung 6 gleichmäßig ausströmt. Die chemische Umsetzung des Precursors zu den für die Beschichtung benötigten Reaktionsprodukten wird durch in der Figur nicht gezeigte, auf den Längsseiten der Ausströmöffnung angeordnete Stützflammen erreicht. Verwendet wird ein titanhaltiger Precursor wie Titantetraisopropylat. Durch das homogene Ausströmen wird eine homogene Schichtabscheidung von Titanoxiden (TiOₓ) mit maximalen Schichtdickenabweichungen von 5% bewirkt. Folgende Parameter wurden gewählt: Mischungsverhältniss Precursor / Sauerstoff 1:1, Durchsatz 20 l/min Precursor, 20 l/min Sauerstoff (O₂), Abstand zwischen der zu beschichtenden Oberfläche 1 und der Ausströmöffnung 6 des Homogenisators 3 von 5 mm bis 20 mm.

Statt des Brenners 2 kann eine ähnlich gestaltete Gasverteilungseinheit zum Einsatz kommen, in der beispielsweise ein mit einem Precursor dotierter Heißgasstrom als Trägergas ein Gemenge G bildet. Die Umsetzung des Precursors erfolgt beispielsweise ohne Flamme im Heißgasstrom oder mittels Stützflammen nach dem Austritt aus der Ausströmöffnung 6. Der Austritt des Gemenges G aus der Ausströmöffnung 6 erfolgt ebenfalls homogen, so dass eine ebenso gleichmäßige Beschichtung der Oberfläche 1 wie mit einem brennbaren Gas erreicht wird. Prinzipiell kann ein solcher Heißgasstrom oder ein kalter Gasstrom als Trägergas auch mit der Beschichtungskomponente beschickt werden, so dass eine Beschichtung ohne vorherige thermische Umsetzung direkt mit der Beschichtungskomponente erfolgt.

Das Gemenge kann unter Verzicht auf den Brenner 2 bzw. die Gasverteilungseinheit direkt über mindestens eine Zuleitung in den Homogenisator eingeleitet, bzw. dort aus dem Trägergas und dem Precursor oder einer Beschichtungskomponente gebildet werden.

Die Verjüngung kann anders als mit geneigten Führungsplatten oder Führungsplattensegmenten erzielt werden. Beispielsweise kann sich die Verjüngung über den gesamten Bereich mindestens einer der Führungsplatten oder mindestens eines der Führungsplattensegmente zwischen einer Einströmöffnung des Homogenisators, die an die Düse bzw. die Gasverteilungseinheit oder die Zuleitung für die direkte Einleitung angrenzt, und der Ausströmöffnung oder über einen oder mehrere Teile dieses Bereiches erstrecken. Als Verjüngung soll auch eine lokale Einschnürung des Strömungsquerschnitts oder eine Folge solcher Einschnürungen verstanden werden, wobei sich der Strömungsquerschnitt nach der Einschnürung wieder vergrößert. Die Verjüngung kann linear oder nichtlinear erfolgen.

### BEZUGSZEICHENLISTE

- 1: Oberfläche
- 2: Brenner
- 3: Homogenisator
- 4: Führungsplatte
- 4.1 bis 4.n: Führungsplattensegmente
- 5: Seitenführungsplatte
- 6: Ausströmöffnung
- 7: Komplexer Körper
- F: Flamme
- G: Gemenge

## Patentansprüche

1. Verfahren zum Beschichten von Oberflächen (1), bei dem ein als Komponenten mindestens ein Trägergas und mindestens einen Precursor und/oder mindestens eine Beschichtungskomponente enthaltendes Gemenge (G) direkt oder über eine Gasverteilungseinheit oder einen Brenner (2) in einen Homogenisator (3) geleitet wird oder das Gemenge (G) dort aus den einzeln eingeleiteten Komponenten gebildet wird, wobei das Gemenge in einem durch zwei einander gegenüber liegende Führungsplatten (4) oder Folgen von Führungsplattensegmenten (4.1 bis 4.n) und zwei einander gegenüber liegende Seitenführungsplatten (5) begrenzten, sich in Richtung einer schlitzförmigen Ausströmöffnung (6) verjüngenden Raum mittels dort entstehender Turbulenzen homogenisiert wird, woraufhin das so homogenisierte Gemenge (G) aus der Ausströmöffnung (6) in Richtung der zu beschichtenden Oberfläche (1) ausgeströmt wird und dort die Beschichtungskomponente und/oder mindestens ein Reaktionsprodukt des Precursors angelagert wird oder werden, wobei die Verjüngung durch eine Neigung mindestens einer der Führungsplatten (4) oder mindestens eines der Führungsplattensegmente (4.1 bis 4.n) bewirkt wird und wobei eine Schlitzbreite der Ausströmöffnung (6) zumindest abschnittsweise durch Schwenken mindestens einer der Führungsplatten (4) oder mindestens eines der Führungsplattensegmente (4.1 bis 4.n) eingestellt wird.

2. Verfahren nach Anspruch 1, **dadurch gekennzeichnet, dass** das Trägergas im Homogenisator (3) und/oder an der Ausströmöffnung (6) verbrannt und der Precursor in der entstehenden Flamme (F) zu mindestens einem Reaktionsprodukt umgesetzt wird.

3. Verfahren nach einem der vorhergehenden Ansprüche, **dadurch gekennzeichnet, dass** ein Homogenisator (3) mit an eine unebene Oberfläche (1) angepasster Ausströmöffnung (6) verwendet wird.

4. Verfahren nach einem der vorhergehenden Ansprüche, **dadurch gekennzeichnet, dass** ein Abstand der Ausströmöffnung (6) von der Oberfläche (1) eingestellt und/oder gesteuert und/oder geregelt wird.

5. Verfahren nach einem der vorhergehenden Ansprüche, **dadurch gekennzeichnet, dass** eine Vorschubgeschwindigkeit einer zwischen der Oberfläche (1) und der Ausströmöffnung (6) stattfindenden Relativbewegung eingestellt und/oder gesteuert und/oder geregelt wird.

6. Verfahren nach Anspruch 5, **dadurch gekennzeichnet, dass** eine Anzahl von Beschichtungszyklen, in denen die Relativbewegung stattfindet, eingestellt und/oder gesteuert und/oder geregelt wird.

7. Verfahren nach einem der vorhergehenden Ansprüche, **dadurch gekennzeichnet, dass** als Precursor ein Stoff verwendet wird, dessen Reaktionsprodukt eine sauerstoffhaltige Verbindung und/oder ein chemisches Element und/oder ein Beschichtungsgemenge aus mindestens einer sauerstoffhaltigen Verbindung und/oder mindest einem chemischen Element ist.

8. Verfahren nach einem der vorhergehenden Ansprüche, **dadurch gekennzeichnet, dass** als Trägergas ein Propan-Luft-Gemisch verwendet wird.

## Claims

1. Method for coating surfaces (1), in which a mixture (G) containing as components at least one carrier gas and at least one precursor and/or at least one coating component is passed directly or via a gas distribution unit or a burner (2) into a homogenizer (3), or the mixture (G) is formed in said homogenizer (3) from the individually introduced components, wherein the mixture is homogenized in a space, which is bounded by two opposite guide plates (4) or sequences of guide plate segments (4.1 to 4.n) and two opposite lateral guide plates (5) and tapers in the direction of a slot-like outflow opening (6), by means of turbulence produced in said space, whereupon the mixture (G) homogenized in this way flows out of the outflow opening (6) in the direction of the surface (1) to be coated and the coating component and/or at least one reaction product of the precursor is or are attached thereto, wherein the narrowing is brought about by an inclination of at least one of the guide plates (4) or at least one of the guide plate segments (4.1 to 4.n) and wherein a slot width of the outflow opening (6) is set at least in portions by pivoting at least one of the guide plates (4) or at least one of the guide plate segments (4.1 to 4.n).

2. Method according to Claim 1, **characterized in that** the carrier gas is combusted in the homogenizer (3) and/or at the outflow opening (6) and the precursor is converted into at least one reaction product in the resultant flame (F).

3. Method according to either of the preceding claims, **characterized in that** a homogenizer (3) having an outflow opening (6) matched to an uneven surface (1) is used.

4. Method according to one of the preceding claims, **characterized in that** the distance of the outflow opening (6) from the surface (1) is set and/or controlled and/or regulated.

5. Method according to one of the preceding claims, **characterized in that** the rate of advance of a relative movement that takes place between the surface (1) and the outflow opening (6) is set and/or controlled and/or regulated.

6. Method according to Claim 5, **characterized in that** the number of coating cycles, in which the relative movement takes place, is set and/or controlled and/or regulated.

7. Method according to one of the preceding claims, **characterized in that** use is made as precursor of a substance, the reaction product of which is an oxygen-containing compound and/or a chemical element and/or a coating mixture composed of at least one oxygen-containing compound and/or at least one chemical element.

8. Method according to one of the preceding claims, **characterized in that** use is made as carrier gas of a propane/air mixture.

## Revendications

1. Procédé de revêtement de surfaces (1), selon lequel un mélange (G) contenant en tant que composants au moins un gaz vecteur et au moins un précurseur et/ou au moins un composant de revêtement est conduit dans un homogénéisateur (3) directement ou par le biais d'une unité de distribution de gaz ou d'un brûleur (2), ou le mélange (G) y est formé à partir des composants introduits individuellement, le mélange étant homogénéisé dans une chambre qui rétrécit dans la direction d'une ouverture de déchargement en forme de fente (6), délimitée par deux plaques de guidage opposées (4) ou succession de segments de plaques de guidage (4.1 à 4.n) et deux plaques de guidage latérales opposées (5), par des turbulences qui se forment dans celle-ci, le mélange (G) ainsi homogénéisé étant ensuite déchargé par l'ouverture de déchargement (6) dans la direction de la surface à revêtir (1), et le composant de revêtement et/ou au moins un produit de réaction du précurseur y étant fixés, le rétrécissement étant réalisé par une inclinaison d'au moins une des plaques de guidage (4) ou d'au moins un des segments de plaques de guidage (4.1 à 4.n), et une largeur de fente de l'ouverture de déchargement (6) étant ajustée au moins dans des sections par pivotement d'au moins une des plaques de guidage (4) ou d'au moins un des segments de plaques de guidage (4.1 à 4.n).

2. Procédé selon la revendication 1, **caractérisé en ce que** le gaz vecteur est brûlé dans l'homogénéisateur (3) et/ou au niveau de l'ouverture de déchargement (6), et le précurseur est transformé en au moins un produit de réaction dans la flamme (F) formée.

3. Procédé selon l'une quelconque des revendications précédentes, **caractérisé en ce qu'**un homogénéisateur (3) ayant une ouverture de déchargement (6) adaptée à une surface (1) inégale est utilisé.

4. Procédé selon l'une quelconque des revendications précédentes, **caractérisé en ce qu'**une distance de l'ouverture de déchargement (6) à la surface (1) est ajustée et/ou contrôlée et/ou réglée.

5. Procédé selon l'une quelconque des revendications précédentes, **caractérisé en ce qu'**une vitesse d'avancement d'un mouvement relatif ayant lieu entre la surface (1) et l'ouverture de déchargement (6) est ajustée et/ou contrôlée et/ou réglée.

6. Procédé selon la revendication 5, **caractérisé en ce qu'**un nombre de cycles de revêtement lors desquels le mouvement relatif a lieu est ajusté et/ou contrôlé et/ou réglé.

7. Procédé selon l'une quelconque des revendications précédentes, **caractérisé en ce qu'**une substance, dont le produit de réaction est un composé contenant de l'oxygène et/ou un élément chimique et/ou un mélange de revêtement constitué d'au moins un composé contenant de l'oxygène et/ou d'au moins un élément chimique, est utilisée en tant que précurseur.

8. Procédé selon l'une quelconque des revendications précédentes, **caractérisé en ce qu'**un mélange propaneair est utilisé en tant que gaz vecteur.
